Europäisches Patentamt

European Patent Office

Office européen des brevets

(11) Veröffentlichungsnummer: **0 483 839 A1**

# EUROPÄISCHE PATENTANMELDUNG

(21) Anmeldenummer: **91118578.3**

(22) Anmeldetag: **31.10.91**

(51) Int. Cl.5: **C23C 14/02**, C23C 16/02, C23G 5/00

(30) Priorität: **02.11.90 DE 4034842**

(43) Veröffentlichungstag der Anmeldung:
**06.05.92 Patentblatt 92/19**

(84) Benannte Vertragsstaaten:
**AT BE CH DE ES FR GB LI LU NL SE**

(71) Anmelder: **Thyssen Edelstahlwerke AG**
**August-Thyssen-Strasse 1**
**W-4000 Düsseldorf(DE)**

(72) Erfinder: **Foller, Michael, Dr. rer. nat.**
**Richard-Strauss-Strasse 3**
**W-4150 Krefeld(DE)**
Erfinder: **Thöne, Carl-Stefan**
**Schwanenweg 1**
**W-8563 Schnaittach(DE)**

(54) **Verfahren zur plasmachemischen Reinigung für eine anschliessende PVD oder PECVD Beschichtung.**

(57) Die Erfindung betrifft ein Verfahren zur Reinigung von Metalloberflächen und anschließenden Beschichtung. Kennzeichen der Erfindung ist, daß die Metalloberflächen (Substrate) durch ein mittels Mikrowellen angeregtes Plasma gereinigt werden und anschließend die Beschichtung durch eine physikalische Dampfphasenabscheidung (PVD) oder eine plasmaaktivierte chemische Dampfphasenabscheidung (PECVD) ausgeführt wird.

EP 0 483 839 A1

Die Erfindung betrifft ein Verfahren zur plasmachemischen Reinigung von Metall-Substraten für eine anschließende PVD- oder PECVD-Beschichtung mittels Mikrowellenplasmen.

Die Haftung von Schichten, die nach den PVD- (Physical Vapor Deposition) oder PECVD- (Plasma Enhanced Chemical Vapor Deposition) - Verfahren abgeschieden werden, ist auf chemische Bindungen zurückzuführen. Die Folge hieraus ist, daß die zu beschichtenden Oberflächen in atomarem Maßstab frei von Verunreinigungen sein müssen, um eine größtmögliche Annäherung der Schichtatome an die Oberflächenatome des Substrates zu gewährleisten.

Der Ausgangszustand einer zu beschichtenden Fläche ist in der Regel in einem undefinierten Zustand. Von dem ungestörten Grundgefüge des Substratmaterials ausgehend, können folgende Schichten, häufig auch gleichzeitig, vorliegen:

- durch die formgebende Verarbeitung verändertes Material
- feste Schicht aus Verunreinigungen, wie Reste von Walzölen, Kühlschmiermittel, Schleif- oder Polierhilfsmittel, Oxide, Ölkohle
- Adsorbatschicht, z.B. Korrosionsschutzmittel, Wasser
- lose Schicht aus festen Verunreinigungen, wie z.B. Staub.

Der genaue Aufbau der Schicht hängt im Detail von der gesamten Vorgeschichte des Werkstücks ab. Dieser undefinierte Aufbau der Oberfläche macht nach Stand der Technik in den meisten Fällen eine mehrstufige komplizierte Vorbehandlung der Werkstücke notwendig, um diese in einen definierten, beschichtungsfähigen Zustand zu versetzen.

Das wohl zur Zeit am häufigsten angewandte Verfahren für die Vorbereitung von Metalloberflächen zur Beschichtung besteht aus folgenden Hauptschritten:

- Grobentfettung in FCKW *)
- Feinwäsche mit wässrigen Reinigern (alkalisch, neutral)
- Spülen mit Wasser
- Trocknung in FCKW *)

Aufgrund der umweltschädigenden Wirkung der FCKW werden erhebliche Anstrengungen unternommen, die Grobentfettung und Trocknung mittels FCKW durch andere Mittel zu ersetzen. Die Grobentfettung kann inzwischen mittels alkalischer Reiniger vorgenommen werden. In der Trocknungsstufe wird versucht, das FCKW durch Reinstwasser (Leitwert 0,05 $\mu$S) und anschließender Heißlufttrocknung oder durch Alkohol zu ersetzen. Diese Techniken besitzen u.a. folgende Nachteile:

- die Verwendung von Reinstwasser führt zu erhöhter Korrosionsgefahr, insbesondere bei niedriglegierten Stählen;
- die Verwendung von Alkohol erfordert zum einen umfangreiche Sicherheitsmaßnahmen (z.B. Ex-Schutz der Anlagen) und zum anderen, insbesondere bei größeren Mengen zu reinigender Teile, eine Destillationseinrichtung zur Abtrennung das Wassers.

Nach unserem Kenntnisstand werden bei einem sowjetischen Verfahren chemisch inerte halogenierte, bei Raumtemperatur feste organische Substanzen verwandt, die bei Kristallisation auf kalten Oberflächen Verunreinigungen einschließen. Nachfolgendes Spülen mit Lösungsmittel, löst die Kristalle mit den Verunreinigungen von der Werkstückoberfläche.

Problematisch ist bei diesem Verfahren

- die Umweltverträglichkeit der fluorierten Salze
- die Spaltgängigkeit
- das Verfahren ist wegen der umfangreichen Aufbereitungsanlage zur Regenerierung der Salze sehr aufwendig.

Neben den hier beschriebenen Grundverfahren sind häufig weitere Reinigungsschritte erforderlich:

- Behandlung in inhibierten Säuren zur Entfernung von Oxiden
- mechanische Bearbeitung durch Strahlen mittels Korund oder Glasperlen

Weiterhin treten eine Reihe von Verunreinigungen auf, die sich nur bedingt beseitigen lassen. Hierzu zählen z.B. Silikonöle, Kunststoffreste, Rückstände von Poliermitteln.

Grundsätzlich wird nach den zuvor beschriebenen Reinigungsprozessen vor der Beschichtung eine Sputterbehandlung, d.h. ein Beschuß der Substratoberflächen mit hochenergetischen Ionen, durchgeführt, um noch verbliebene oder nach der Reinigung neu aufgetretene Verunreinigungen zu entfernen. Hierbei wird häufig mit Edelgasionen gearbeitet, die in einer DC-Glimmentlasung erzeugt und auf die Substratoberfläche hin beschleunigt werden. Eine Variante besteht daran, daß statt der Edelgasionen Metallionen verwendet werden.

*) Fluorchlorkohlenwasserstoff

Neber der DC-Glimmentladung kommt auch die HF-Glimmentladung bei 13,6 MHz zum Einsatz. Die Vorteile einer HF-Entladung gegenüber der DC-Entladung liegen in folgenden Punkten:

1. Es wird ein höherer Ionisierungsgrad erzielt.

2. Oxide, die sich bei einer DC-Entladung positiv aufladen und damit einen Ionenbeschuß verhindern, können bei einer HF-Entladung effektiv abgetragen weren, da wegen des Wechselfeldes die positive Aufladung während der nächsten Halbwelle durch Elektronenbeschuß aufgehoben wird.

3. Wegen der besonderen Eigenschaften eines Hochfrequenzplasmas, läßt sich eine gleichmäßigere Behandlung komplizierter Teile oder Chargierungen durchführen.

Nachteilig erweist sich der Einsatz von HF-Plasmen bei einer Frequenz von 13,6 MHz in folgenden Punkten:

- es ist sehr problematisch, Beschichtungsanlagen mit einer Einrichtung zur Erzeugung von Hochfrequenzplasmen in diesem Frequenzbereich nachzurüsten und zu betreiben. Es ist schwierig, die Streustrahlung abzuschirmen;

- das Sputterverfahren arbeitet nicht selektiv, d.h. nicht nur Verunreinigungen, sondern auch das Grundmaterial werden angegriffen;

- das Sputterverfahren beinhaltetet, daß Redepositionseffekte auftreten. Da durch den Prozeß kaum gasförmige und damit über die Vakuumpumpen aus der Anlage entfernbare Stoffe erzeugt werden, diffundieren die durch Impulsübertrag herausgeschlagenen Oberflächenatome durch die Kammer und kondensieren an den Wänden oder Substraten. Ein optimaler Reinigungseffekt kann daher nur erzielt werden, wenn die innere Oberfläche der Kammer einem Vielfachen der Substratoberfläche entspricht. Das Flächenverhältnis ist im Fall der Kammerbeladung mit vielen kleinen Werkstücken aber häufig umgekehrt.

Ein optimales Reinigungsverfahren für eine anschließende PVD oder PECVD-Beschichtung von Metalloberflächen sollte folgende Anforderungen erfüllen:

1. Möglichst universelle Reinigungswirkung für Öle, Fette, Kunststoffreste, eingebrannte, verharzte Öle, Oxide, Schleif- und Polierhilfsmittel,

2. Wirtschaftlichkeit,

3. Umweltverträglichkeit,

4. Einfache Handhabung insbesondere in einer Produktionslinie, möglichst automatisierbar,

5. die Reinigung sollte in-situ in der Beschichtungskammer erfolgen, um eine Rekontamination nach der Reinigung zu vermeiden und um auf reaktiven Oberflächen zu beschichten,

6. das Verfahren muß kompatibel zur angewandten Beschichtungstechnik sein, bestehende Anlagen sollten nachrüstbar sein,

7. durch den Reinigungsprozeß darf keine negative Beeinflussung der Substratoberfläche und des Grundmaterials auftreten (z.B. Aufrauhungen, Korrosion),

8. das Verfahren muß eine hohe Spaltgängigkeit besitzen,

9. das metallische Substat sollte auf atomarer Basis freigelegt werden.

Es ist Aufgabe der Erfindung, die Reinigung der Substrate vor einer Beschichtung zu vereinfachen und dabei den Einsatz von FCKW zu vermeiden. Es ist weiterhin die Aufgabe, die Anforderungen 1 bis 9 zu erfüllen. Es ist zusätzlich die Aufgabe der Erfindung, ein Verfahren zu schaffen, bei dem so aktivierte Substratoberflächen (in situ) erzeugt werden, daß anschließend auch Kaltarbeitsstähle bei ca. 180 bis 300 ° C haftfest beschichtet werden können, ohne die Stähle zu überhitzen und damit zu erweichen.

Insbesondere ist es die Aufgabe der Erfindung, Silikonöle überhaupt entfernen zu können, denn zur Zeit ist die Entfernung von Silikon nach Stand der Technik ein Glücksspiel und damit Zufall.

Die Aufgabe wird dadurch gelöst, daß die letzte Reinigungsstufe in einer Vakuumkammer nach Art einer plasmatechnischen Reinigung, aber mit Hilfe einer Mikrowellen- (z.B. 2,5 GHz) unterstützung durchgeführt wird und anschließend die PVD- oder PECVD-Beschichtung vorgenommen wird. Dabei wird Sauerstoff und Wasserstoff als Arbeitsgas im Wechsel verwendet. Mindestens ein Wechsel, z.B. erst Sauerstoff dann Wasserstoff, muß erfolgen. Noch zweckmäßiger ist ein zweimaliger Wechsel, z.B. in der Reihenfolge Wasserstoff, Sauerstoff, Wasserstoff.

Es handelt sich um die Kombination zweier Verfahren 1. plasmachemische Reinigung mittels Plasmen, die durch ein Mikrowellenfeld angeregt werden, 2. Beschichtung von Werkstücken durch ein PVD- oder PECVD-Verfahren.

Es ist bekannt, daß in einem durch eine äußere Spannung angeregten Plasma der Ionisationsgrad des Arbeitsgases und der Anteil angeregter Atome oder Moleküle (Radikale) um so größer ist, je höher die Frequenz der anregenden Spannung ist. Dieses bedeutet, daß die Effektivität eines plasmachemischen Prozesses mit zunehmender Frequenz ebenfalls zunimmt. Aus diesem Grunde werden nach Stand der Technik, aber in anderen Anwendungsgebieten, nämlich zur Reinigung und zur Modifizierung von Kunststoffoberflächen, Mikrowellenplasmen eingesetzt. Es wurde nun gefunden, daß sich Mrikowellenplasmen auch zur Metallsubstratreinigung direkt vor dem Beschichtungsprozeß mit Erfolg einsetzen lassen. Die Reinigung von Metalloberflächen als Teil des erfindungsgemäßen Verfahrens für eine anschließende PVD- oder PECVD-Beschichtung gliedert sich in folgende Schritte auf:

1. Grobentfettung in einem alkalischen Reiniger. Hierbei werden auch feste Anteile, wie Späne und Staub im Ultraschallbad entfernt;

2. Spülen in deionisiertem Wasser in einer Spülkaskade;

3. Zur Vermeidung von Trockenflecken spülen in Reinstwasser mit Korrosionsschutzzusatz oder spülen in deionisiertem Wasser mit einem Netzmittelzusatz zur Vermeidung der Tropfenbildung;

4. Trocknen in Heißluft oder Abblasen mit Preßluft oder $N_2$ und Trocknung im Vakuum. Die bei der Trocknung im Vakuum üblicherweise auftretenden Probleme wie z.B. Vereisung des Wassers in Sacklöchern werden dadurch behoben, daß die Werkstücke im Plasma erwärmt werden.

5. Chargierung der Teile in der Beschichtungsanlage oder in einer gesonderten Reinigungskammer, wobei die Beschichtungskammer vorzuziehen ist, da in situ gereinigt und nach der Reinigung kein Transfer durch die Luft notwendig wird. Hierbei könnten sonst erneut Oxide, Staub- und Gasabsorption sowie Wasserabsorption auftreten. Die zur plasmachemischen Reinigung benutzte Kammer ist mit einer oder mehreren Mikrowellenplasmaquellen ausgerüstet, die entweder im Druckbereich zwischen $10^{-4}$ und $10^{-2}$ mbar im ECR-Modus (ECR: Elektron-Cyclotron-Resonanz) oder zwischen $10^{-2}$ und 10 mbar mit üblichen Hornstrahlern arbeiten. Es ist auch denkbar, die Kammer mit beiden Arten der Plasmaquellen gleichzeitig auszurüsten.

Es wurde weiterhin gefunden, daß zur Ausführung der Erfindung eine besondere Vorrichtung nötig ist. Die Austrittsöffnung der Quelle sollte während des Beschichtungsvorganges mit einem Verschluß, genannt Shutter, abgedeckt werden, um eine Schichtbildung auf dem Quarzdorn der Quelle und damit eine verminderte Transmission zu vermeiden. Der Shutter kann z.B. aus einem Plattenventil bestehen, das zwischen Kammer und Quelle angebracht ist oder aus einer Platte oder einem Blech, das vor die Austrittsöffnung der Quelle gedreht, geschoben, gerollt oder geklappt wird. Als Arbeitsgase zur Plasmareinigung kommen in der reduzierenden Betriebsphase Wasserstoff, in der oxidierenden Phase Sauerstoff zum Einsatz. Die Beimischung eines Edelgases ist in beiden Phasen ebenfalls möglich.

Die Substrate werden ggf. gegenüber der Kammerwand auf ein negatives Potential gelegt, um eine Temperaturerhöhung zur Beschleunigung der Reinigungsreaktion und zur besseren Abfuhr der erzeugten flüchtigen Spezies zu erzielen. Weiterhin kann der Reinigungseffekt durch einen Ionenbeschuß bei Anwesenheit eines Edelgases erhöht werden. Erfolgt die Trocknung in der Kammer, wird diese ebenfalls durch die Temperaturerhöhung beschleunigt. Die reduzierende Phase mittels Wasserstoffplasma verfolgt grundsätzlich folgende Ziele:

- Reduktion von Oxiden
- Zersetzung von Silikonölen.

Der Behandlung im Wasserstoffplasma folgt eine oxidative Behandlung im Sauerstoffplasma (oder alternativ in einem fluorierten Gas), um organische Stoff zu zerlegen und zu entfernen. Öle und Fette werden in flüchtige Spezies, wie CO, $CO_2$, $H_2O$ umgewandelt und über die Vakuumpumpen aus der Anlage entfernt. Auch hier kann durch Zugabe eines Edelgases der Ablauf durch einen zusätzlich eingeschalteten Sputterprozeß unterstützt werden.

An die oxidierende Behandlung schließt sich eine abschließende reduzierende Phase an, um die im Sauerstoffplasma entstandenen Metalloxide zu reduzieren, so daß nach Abschluß des Prozesses eine hochreaktive, aktivierte Metalloberfläche vorliegt, die hervorragend für eine anschließende Hartstoffbeschichtung präpariert ist.

Die Anregung des Plasmas mit Frequenzen im Mikrowellenbereich (z.B. 2,5 GHz) besitzt drei besondere Vorteile gegenüber der Anregung im Radiofrequenzbereich von z.B. 13,6 MHz:

- höherer Anteil an Ionen und Radikalen,
- problemlose Abschirmung, so daß eine Nachrüstung bestehender Anlagen ohne großen Aufwand möglich ist,
- keine Abstimmungsprobleme.

Durch die Einführung der plasmachemischen Reinigung mittels Mikrowellenplasmen ergeben sich folgende herausragende Vorteile:

- keine Umweltbelastung, da ungefährliche Reaktionsprodukte entstehen, keine Entsorgungskosten,
- Vermeidung von FCKW,
- universelles Reinigungsverfahren,
- in-situ Reinigung,

- die von der Oberfläche entfernten Spezies werden im Gegensatz zur Sputtertechnik aus der Anlage entfernt,
- hohe Spaltgängigkeit,
- keine Beeinflussung des Substratmaterials, keine Aufrauhung der Oberfläche,
- einfache, automatisierbare Handhabung,
- geringer apparativer Aufwand, weniger Kosten und Platzbedarf.

Außerdem läßt sich der erfindungsgemäße Prozeß außerordentlich schnell durchführen. Es wurde weiterhin gefunden, daß die Zykluszeit der PVD- oder PECVD-Anlage nur um 10 bis 20 Minuten verlängert wird, auch wenn man alle drei durch das Mikrowellenplasma unterstützten Teilschritte reduzierend/oxidierend/reduzierend ausführt.

Die weiteren speziellen, besonders vorteilhaften Ausführungsformen der Erfindung werden nun anhand der Unteransprüche erläutert.

Die Anwendung des Reinigungsverfahrens in der gleichen Kammer, in der auch die Beschichtung vorgenommen wird, führt

a) zu aktivierten Metalloberflächen, die keine Neubelegung durch Sauerstoff oder/und Luftfeuchtigkeit aufweisen,

b) zur gleichzeitigen zumindest teilweisen Reinigung der Kammer-Einbauten, wie z.B. des Chargiergestelles.

Der Shutter schützt die Mikrowelleneinrichtung während des Beschichtungsprozesses. Es wird vorzugsweise nach Art einer Klappe ausgeführt, die rechnergesteuert betätigt werden kann.

Während der reduzierenden und oxidierenden Reinigungsphase regelt man vorzugsweise den Druck auf $10^{-4}$ bis $10^{-2}$ mbar. Der Druck wird bei Verwendung einer oder mehrerer ECR-Phasen eingestellt.

Durch Einsatz von Edelgasen im Gemisch mit $H_2$ oder $O_2$ wird der zusätzliche "Sputtereffekt" erzeugt und die Lebensdauer der im Plasma erzeugten Radikale erhöht.

Ein negatives Potential von bis zu 5000 V gegenüber der Kammerwand erhöht die Reinigungswirkung des erfindungsgemäßen Prozesses, in dem die Sputterwirkung verstärkt wird.

Eine hohe Substrattemperatur bei Schnellarbeitsstählen bis zu 500°C hat sich als besonders wirksam während der Reinigung herausgestellt. Die Zyklen nach den Ansprüchen 10 bis 12 werden vorzugsweise so gefahren, daß das Substrat von Raumtemperatur auf Beschichtungstemperatur mit dem Reinigungsprozeß vorgeheizt wird. Damit wird durch die Reinigungszeit nicht die gesamte Zyklenzeit verlängert.

Die Entfernung von anhaftenden Partikeln am Substrat mit Hilfe von Ultraschall-unterstützten Bädern/Wäsche ist an und für sich bekannt und auch hier nützlich.

Die Erfindung wird anhand der Ausführungsbeispiele erläutert.

## 1. Ausführungsbeispiel

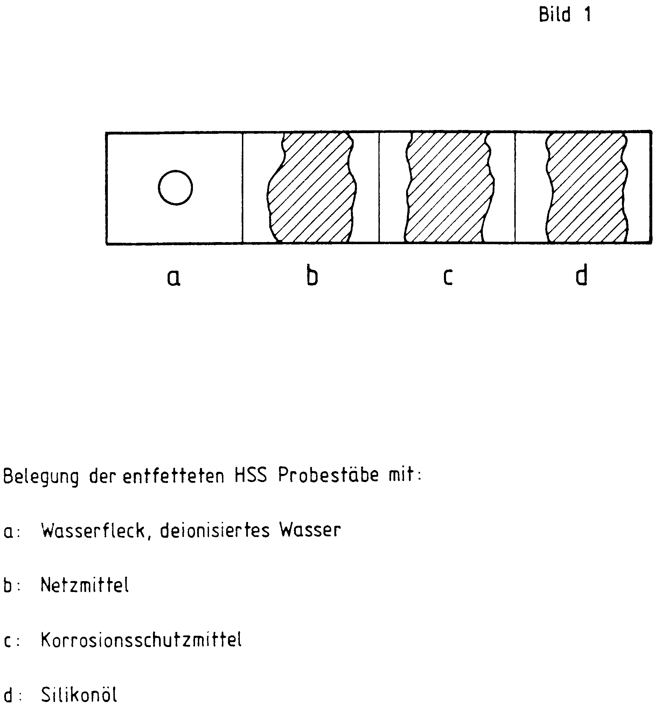

6 Probestäbe aus HSS (Werkstoff-Nr. 1.3207. Feinschliff) wurden mittels Ultraschall gerinigt (Kaltreiniger (Eskapon), Isopropanol, Äther) und definiert jeweils mit Silikonöl, Korrosionsschutzöl, Netzmittel und einem Trockenfleck belegt (s. Bild 1).

Anschließend wurden die Proben mittels Mikrowellenplasmen gereinigt (Parameter: s. Versuchsprotokoll Tabelle 1). Es wurde bewußt mit langen Behandlungszeiten gearbeitet, um einen sicheren Effekt zu erzielen und den abschwächenden Einfluß eines in der benutzten Kammer eingebauten Faradaykäfigs auszugleichen.

Die Proben wurden in Aluminiumfolie und Plastiktüten (mit Inertgas gespült) verpackt. Nach ca. 2 Wochen wurden die Stäbe ohne Vorreinigung mit TiN mit Hilfe des PVD-Verfahrens beschichtet.

## Versuchsergebnisse

Zur Kontrolle des Reinigungseffektes wird das Haftvermögen der PVD-Schicht herangezogen.

## Optische Beurteilung

Lediglich in den Bereichen, in denen konzentriertes Netzmittel aufgetragen wurde, treten bei den Proben 1, 2, 3 und 6 punktartige Schichtfehler auf. Teilweise sind die Wasserflecken noch schwach erkennbar, rufen allerdings keine Fehler hervor. Ansonsten sind die Schichten fehlerfrei.

Scratch-Test

Die kritischen Lasten aus den Scratch-Versuchen sind in Tabelle 2 aufgetragen.

Aus der optischen Beurteilung der Scratch-Spur und den kritischen Lasten ergibt sich folgende Beurteilung für das Haftvermögen:

Probe 2 ($O_2$/$CF_4$ Behandlung) zeigt eine schlechte Schichthaftung in allen Bereichen mit großflächigen Abplatzungen in der Umgebung des Scratches. Dies ist im Vergleich zu den anderen Proben ein unerwartetes Ergebnis, da mittels der Flourgase allgemein ein besserer Reinigungseffekt erzielt wird. Möglicherweise liegt hier ein Verfahrensfehler bei der Reinigung vor.

Die silikonbehafteten Partien weisen niedrige Werte für die kritische Last auf. Dies ist darauf zurückzuführen, daß zunächst oxidativ behandelt wurde, so daß $SiO_2$ entsteht. Bei der Entfernung von Silikon muß jedoch zunächst reduktiv gearbeitet werden, um über die Bildung von $SiH_4$ das Silizium zu entfernen, wie ein weiterer Versuch gezeigt hat.

Im Bereich der Wasserflecken treten keine bemerkenswerten Haftungsprobleme auf.

Über die Einsetzbarkeit von Netzmitteln kann hieraus noch keine konkrete Aussage gemacht werden, da dieses unverdünnt und damit dick aufgetragen wude. Unter normalen Einsatzbedingungen handelt es sich um monomolekulare Schichten. Weitere Versuche zeigten, daß sich die dünnen Netzmittelschichten entfernen ließen.

Aufgrund der Werte für die kritischen Lasten und die optische Beurteilung der Scratch-Spuren ist die Haftung der Schicht, insbesondere in den Bereichen Korrosionsschutzmittel und Waserfleck trotz der langen Zwischenlagerung, als gut bis sehr gut zu bezeichnen. Mittels eines Mikrowellenplasmas wird eine gute Reinigungswirkung erzielt. Diese wird durch einen Prozeß, der "in situ" durchgeführt wird, noch deutlich gesteigert, wie das zweite Ausführungsbeispiel lehrt.

2. Ausführungsbeispiel

Acht Probestäbe aus HSS (Werkstoff-Nr. 1.3207, Feinschliff) wurden in einem Kaltreiniger (Eskapon) mit Ultraschallunterstützung gereinigt, mit deionisiertem Wasser abgespült, in ein mit einem Netzmittel versetztes Wasserbad getaucht und mit Heißluft getrocknet (Probe 1 bis 6) bzw. mit Druckluft abgeblasen (Probe 7 und 8).

Die gereinigten Stäbe wurden anschließend mit einem Gemisch aus einem Korrosionsschutzmittel (Lyran C 70) und einem Silikonöl (DC 704) schwach eingerieben und in eine PVD-Arc-Anlage chargiert.

Die PVD-Anlage ist mit einer Mikrowellen-Plasmaquelle ausgerüstet, die mittels eines Elektromagnetes im ECR (Elektron-Cyclotron-Resonanz) Modus betrieben werden kann.

Die Versuchsparameter zur plasmachemischen Behandlung der Probestäbe im Mikrowellenplasma sind in Tabelle 3 aufgelistet.

Der Plasmareinigungsprozeß wurde jeweils in der Abpumpphase bei Erreichen eines Druckes von $1 \times 10^{-2}$ mbar gestartet. Bei ähnlicher Kammerbeladung wird üblicherweise vom Beginn des Evakuierens einschließlich des Aufheizens der Werkstücke bis zum Beginn der Beschichtungsphase eine Prozeßzeit von ca. 30 Minuten benötigt. Durch die Verwendung der Mikrowellenplasmareinigung erhöht sich die Dauer dieser Phase auf ca. 45-50 Minuten.

Nach abgeschlossener Plasmareinigung wurden die Probestäbe direkt ohne eine Unterbrechung des Vakuums mit einer 3 $\mu$m dicken TiN-Schicht zur Überprüfung des Reinigungseffekts beschichtet. Die anschließend aus dem Scratch-Test gewonnenen Werte für die kritische Last sind ebenfalls Tabelle 3 zu entnehmen.

Diese zeigen, daß durchgehend hohe Werte für die kritische Last, d.h. ein guter Reinigungseffekt erreicht wurde. Lediglich die Proben, die im ersten Behandlungsschritt einem reinen Sauerstoffplasma ausgesetzt waren, zeigen erwartungsgemäß ein schlechteres Ergebnis. Bei der optischen Beurteilung sind auf keiner Probe Schichtfehler zu erkennen.

Tabelle 1

<p style="text-align:right">EP 0 483 839 A1</p>

## Protokoll
## Hornstrahler

| Proben-Nr.: | 1 | 2 | 3 | 4 | 5 | 6 |
|---|---|---|---|---|---|---|
| **Gas 1:** | | | | | | |
| ml/min | $O_2$ 500 | $O_2$ 500 | $O_2$ 500 | $O_2$ 500 | $O_2$ 500 | $O_2$ 500 |
| **Gas 2:** | --- | $CF_4$ 50 | --- | --- | --- | --- |
| **Druck:** | | | | | | |
| mbar | 1.6 | 1.8 | 1.6 | 1.6 | 1.6 | 1.6 |
| **HF-Leistung:** | | | | | | |
| Watt | 600 | 600 | 600 | 600 | 600 | 600 |
| **Prozeßzeit:** | | | | | | |
| Min. | 45 | 45 | 60 | 75 | 90 | 105 |
| **Faradaykäfig** | ja | ja | ja | ja | ja | ja |

Alle Teile wurden vor der Plasmabehandlung mit Sauerstoff im Trockenschrank auf 250°C aufgeheizt. Nach der Sauerstoffbehandlung wurde eine 60 minütige Reduktion im Wasserstoffplasma durchgeführt.

Tabelle 2

Kritische Last in N

Abhängigkeit der kritischen Last in N von der Oberflächenbelegung und der Plasmareinigung bei unterschiedlichen Behandlungszeiten und Gasen

| Probe | 1 | 2 | 3 | 4 | 5 | 6 |
|---|---|---|---|---|---|---|
| Belegung | | | | | | |
| Wasserfleck | 70 | 10 | 74 | 78 | 54 | 66 |
| Netzmittel | | | | | 22 | |
| Korrosions- | | | | | | |
| schutzöl | 54 | 8 | 49 | 48 | 50 | 46 |
| Silikonöl | 36 | 10 | (0) | 45 | 30 | 66 |

Kritische Lasten von 40-50 N werden bei der Beurteilung des Haftvermögens als "gut" eingestuft.

8

EP 0 483 839 A1

|  |  | Probe 1/2 | Probe 3/4 | Probe 5/6 | Probe 7/8 |
|---|---|---|---|---|---|
| DC-Bias | (V) | 0 |  |  | 300 |
| HF-Leistung | (W) | 600 |  |  | 600 |
| Druck | (mbar) | $5 \times 10^{-3}$ |  |  | $1 \times 10^{-2}$ |
| Dauer | (min) | 10 |  |  | 10 |
| Temp. | (K) | 330 |  |  | 380 |
| Gasfluß | (sccm) | 250 $H_2$ |  |  | 250 $H_2$  250 Argon |
| DC-Bias | (V) | 0 | 0 | 200 | 300 |
| HF-Leistung | (W) | 600 | 600 | 600 | 600 |
| Druck | (mbar) | $1 \times 10^{-2}$ | $1 \times 10^{-2}$ | $1 \times 10^{-2}$ | $1 \times 10^{-2}$ |
| Dauer | (min) | 15 | 20 | 20 | 15 |
| Temp. | (K) | 380 | 350 | 570 | 570 |
| Gasfluß | (sccm) | 250 $O_2$ | 250 $O_2$ | 25 $CF_4$/220 $O_2$ | 250 $O_2$ |
| DC-Bias | (V) | 0 | 0 | 200 | 300 |
| HF-Leistung | (W) | 600 | 600 | 600 | 600 |
| Druck | (mbar) | $5 \times 10^{-3}$ | $5 \times 10^{-3}$ | $5 \times 10^{-3}$ | $5 \times 10^{-4}$ |
| Dauer | (min) | 15 | 15 | 15 | 15 |
| Temp. | (K) | 380 | 360 | 630 | 780 |
| Gasfluß | (sccm) | 250 $H_2$ | 250 $H_2$ | 250 $H_2$ | 250 $H_2$ |
| kritische Last (N) |  | 75/68 | 35/44 | 67/72 | 65/78 |

Tabelle 3

**Patentansprüche**

1. Verfahren zur Reinigung von Metalloberflächen und anschließenden Beschichtung, dadurch gekennzeichnet, daß die Metalloberflächen (Substrate) durch ein mittels Mikrowellen angeregtes Plasma mit Sauerstoff und Wasserstoff als Arbeitsgas im Wechsel mit mindestens einmaligem Wechsel gereinigt werden und anschließend die Beschichtung durch eine physikalische Dampfphasenabscheidung (PVD) oder eine plasmaaktivierte chemische Dampfphasenabscheidung (PECVD) ausgeführt wird.

2. Verfahren nach Anspruch 1, dadurch gekennzeichnet, daß die Behandlung der Substrate mittels Mikrowellen innerhalb der Beschichtungskammer der PVD- oder PECVD-Anlage durchgeführt wird.

3. Verfahren nach Anspruch 2, dadurch gekennzeichnet, daß die Austrittsöffnung der Mikrowellenplasmaquelle während der Beschichtungsphase durch einen Schließmechanismus (Shutter) abgedeckt wird.

4. Verfahren nach Anspruch 3, dadurch gekennzeichnet, daß in der Vakuumkammer ein Arbeitsdruck von $10^{-4}$ bis $10^{-2}$ mbar herrscht.

5. Verfahren nach Anspruch 4, dadurch gekennzeichnet, daß dem Arbeitsgas ein oder mehrere Edelgase zugemischt werden.

6. Verfahren nach Anspruch 5, dadurch gekennzeichnet, daß die Substrate durch Anlegen einer äußeren Spannung bis 5000 V gegenüber der Kammerwand auf einem negativen Potential erwärmt werden.

7. Verfahren nach Anspruch 6, dadurch gekennzeichnet, daß die Substrate aus Werkzeugstahl nicht höher als ca. 600° C, die Substrate aus Hartmetall nicht höher als 750° C bei einer tieferen Temperatur, vorzugsweise bei Raumtemperatur beginnend während der Reinigung erwärmt werden.

8. Verfahren nach Anspruch 1, dadurch gekennzeichnet, daß die Vorreinigung der Substrate durch Entfetten, Spülen, Trocknen unter teilweiser Nutzung von Ultraschallwellen durchgeführt wird.

Bild 1

Belegung der entfetteten HSS Probestäbe mit:

a: Wasserfleck, deionisiertes Wasser

b: Netzmittel

c: Korrosionsschutzmittel

d: Silikonöl

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | PATENT ABSTRACTS OF JAPAN vol. 12, no. 479 (C-552)(3326) 14. Dezember 1988 & JP-A-63 195 266 ( SEMICONDUCTOR ENERGY LAB. CO. LTD. ) 12. August 1988 * Zusammenfassung * | 1,2 | C23C14/02 C23C16/02 C23G5/00 |
| | --- | | |
| A | EP-A-0 280 539 (SEMICONDUCTOR ENERGY LAB. CO. LTD.) * Ansprüche 1,3,8 * | 1-3,5 | |
| | --- | | |
| A | PATENT ABSTRACTS OF JAPAN vol. 12, no. 180 (P-709)(3027) 27. Mai 1988 & JP-A-62 291 664 ( SHARP CORPORATION ) 18. Dezember 1987 * Zusammenfassung * | 1,2 | |
| | --- | | |
| A | JOURNAL OF VACUUM SCIENCE AND TECHNOLOGY,A Bd. 6, Nr. 3, 1. Mai 1988, WOODBURY, NY, USA Seiten 1266 - 1274; M. GRUNZE ET AL.: 'chemical cleaning of metal surfaces in vacuum systems by exposure to reactive gases' * Tabelle 1 * | 1 | RECHERCHIERTE SACHGEBIETE (Int. Cl.5) |
| | --- | | C23C |
| A | EP-A-0 160 202 (OVONIC SYNTHETIC MATERIALS CO. INC.) * Seite 10, Zeile 1 - Zeile 30 * | 3,4,8 | C23G |
| | --- | | |
| A | GB-A-2 086 943 (SUMITOMO ELECTRIC INDUSTRIES LTD.) * Beispiele 1,2 * | 6,7 | |
| | ----- | | |

Der vorliegende Recherchenbericht wurde für alle Patentansprüche erstellt

| Recherchenort | Abschlußdatum der Recherche | Prüfer |
|---|---|---|
| DEN HAAG | 23 JANUAR 1992 | EKHULT H.U. |